(19) Europäisches Patentamt
European Patent Office
Office européen des brevets

(11) **EP 4 597 681 A1**

(12) **EUROPEAN PATENT APPLICATION**
published in accordance with Art. 153(4) EPC

(43) Date of publication:
06.08.2025 Bulletin 2025/32

(21) Application number: 23871452.1

(22) Date of filing: 02.08.2023

(51) International Patent Classification (IPC):
*H01M 10/42* (2006.01)    *H01M 10/48* (2006.01)
*H01M 50/202* (2021.01)   *H01M 50/204* (2021.01)
*H01M 50/247* (2021.01)   *H01M 50/249* (2021.01)
*H01M 50/251* (2021.01)   *H01M 50/284* (2021.01)
*H02J 7/00* (2006.01)

(52) Cooperative Patent Classification (CPC):
H01M 10/42; H01M 10/48; H01M 50/202;
H01M 50/204; H01M 50/247; H01M 50/249;
H01M 50/251; H01M 50/284; H02J 7/00

(86) International application number:
PCT/JP2023/028287

(87) International publication number:
WO 2024/070210 (04.04.2024 Gazette 2024/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.09.2022 JP 2022157581

(71) Applicant: Panasonic Energy Co., Ltd.
Osaka 570-8511 (JP)

(72) Inventors:
• KIYOHARA, Yoshikazu
  Kadoma-shi, Osaka 571-0057 (JP)
• HASHIMOTO, Koji
  Kadoma-shi, Osaka 571-0057 (JP)
• MIYAJI, Shusuke
  Kadoma-shi, Osaka 571-0057 (JP)

(74) Representative: Novagraaf International SA
Chemin de l'Echo 3
1213 Onex, Geneva (CH)

(54) **POWER SUPPLY DEVICE RECYCLING METHOD**

(57) A method of easily recycling power supply devices is provided. Each power supply device includes battery blocks (10) and a circuit board (30) accommodated in a housing (20), each of the battery blocks (10) including secondary battery cells. The method includes: measuring resistance values based on current and voltage values of the devices before and after starting one of charging and discharging of power supply devices (100) for a predetermined time not longer than 10 seconds and based on current and voltage values after finishing the one of charging and discharging of the devices; grouping one or more power supply devices (10), the one or more power supply devices each having a difference between the resistance values which is within a predetermined range; taking out the battery blocks (10) accommodated in the housing (20) by disassembling the devices; and reproducing, according to a result of the grouping, a power supply device: by constituting a new power supply device (100') by accommodating the battery blocks in a new housing; or by reproducing a power supply device by combining a new battery block with a separated housing (20) and a separated circuit board (30).

FIG. 4

## Description

### TECHNICAL FIELD

The present disclosure relates to a method of recycling a power supply device.

### BACKGROUND ART

Power supply devices each including a rechargeable secondary battery, such as a lithium-ion secondary battery, are used for various kinds of applications such as a backup power supply for a server, a power storage device for peak-cut, or a power supply for driving an electric vehicle. Specifications of the power supply devices are different depending on applications to be used. For instance, a backup power supply for a server requires very high performance, so that the backup power supply for a server may often be disposed of in a short period of time. For instance, even if being usable for other applications such as a power storage device, the backup power supply for a server may be disposed of conventionally.

On the other hand, secondary-battery recycling is needed from viewpoints of recent emphasis on environmental impact, resource depletion, SDGs, or the like. To achieve these, various kinds of technologies have been proposed (e.g., PTL 1). However, industrialization of the recycling has been difficult because of its so complicated processes.

### CITATION LIST

Patent Literature

PTL 1: Japanese Patent Laid-Open Publication No. 2021-093247
PTL 2: Japanese Patent Laid-Open Publication No. 2018-156768
PTL 3: Japanese Patent Laid-Open Publication No. 2009-021021
PTL 4: Japanese Patent Laid-Open Publication No. 2015-076165

### SUMMARY OF INVENTION

### TECHNICAL PROBLEM

One of objects of the present disclosure is to provide a method of easily recycling a power supply device.

### SOLUTION TO PROBLEM

A method of recycling a power supply device according to an aspect of the present disclosure is a method of recycling power supply devices. Each of the power supply devices includes a plurality of battery blocks, a circuit board, and a housing accommodating the plurality of battery blocks and the circuit board therein. Each of the plurality of battery blocks including a plurality of secondary battery cells. The method comprises: measuring resistance values of the power supply devices based on current values and voltage values of the power supply devices before and after starting one of charging and discharging of the power supply devices for a predetermined time not longer than 10 seconds and based on current values and voltage values after finishing the one of charging and discharging of the power supply devices; grouping one or more power supply devices out of the power supply devices, the one or more power supply devices each having a difference between the resistance values which is within a predetermined range; separating the housing, the circuit board, and the plurality of battery blocks from one another by disassembling the one or more power supply devices; and reproducing, according to a result of said grouping, a power supply device by: producing a new power supply device by accommodating the plurality of battery blocks in a new housing; or reproducing a power supply device by combining a new battery block with the separated housing and the separated circuit board.

### ADVANTAGEOUS EFFECT OF INVENTION

According to the power supply device recycling method in accordance with one aspect of the present invention, power supply devices, each having a resistance value within a predetermined range, are grouped to each other. After that, a housing, a circuit board, and battery blocks are separated and reconstituted to construct a new power supply device, thereby making it possible to reuse the power supply device.

### BRIEF DESCRIPTION OF DRAWINGS

FIG. 1 is a perspective view of a power supply device in accordance with an exemplary embodiment.
FIG. 2 is an exploded perspective view of the power supply device shown in FIG.1.
FIG. 3 is an exploded perspective view of a battery module shown in FIG. 2 disassembled into battery blocks.
FIG. 4 is a schematic diagram showing an example of a method of recycling a power supply device recycling method.
FIG. 5 is a flowchart showing an example of the method of recycling the power supply device.
FIG. 6 is a flowchart showing another example of method of recycling the power supply device.
FIG. 7 is a schematic diagram showing an example of the battery blocks grouped.

FIG. 8 is a circuit diagram of a resistance measurement circuit that measures resistance values of the battery blocks.

FIG. 9 shows a time change of charging current and charging voltage measured by the resistance measurement circuit shown in FIG. 8.

FIG. 10 is a circuit diagram of another example of the resistance measurement circuit.

FIG. 11 shows a time change of charging current and charging voltage measured by the resistance measurement circuit shown in FIG. 10.

FIG. 12 is a circuit diagram of another example of the resistance measurement circuit.

FIG. 13 shows a time change of charging current and charging voltage measured by the resistance measurement circuit shown in FIG. 12.

FIG. 14 is a schematic diagram of a thermistor connected to a secondary battery cell.

FIG. 15 is a schematic diagram of an example of a connection between the battery block and the circuit board through a bus bar.

FIG. 16 is a perspective view of a bus bar of Example 1.

FIG. 17 is a perspective view showing a bus bar of a comparative example.

FIG. 18 is a cross-sectional view of a contact point between the circuit board and a bus bar of Example 2.

FIG. 19 is an exploded perspective view of the battery block shown in FIG. 2 to show an angle steel separated from the battery block.

FIG. 20 is an exploded perspective view of a battery block with different specification connected to the angle steel shown in FIG. 19.

FIG. 21 is a horizontal cross-sectional view of a power supply device of Example 3.

FIG. 22 is a horizontal cross-sectional view of a power supply device of a comparative example.

DESCRIPTION OF EMBODIMENT

Aspects of the present invention may be specified by the following configuration and features.

In a method of recycling the power supply device in accordance with another aspect of the present invention, in the above-mentioned aspect, said measuring the resistance values comprises: calculating a first resistance value R1 using Expression 1, wherein a voltage value of each power supply device at a time T1 before starting charging the each power supply device is V1, a voltage value of the each power supply device at a time T2 immediately after staring charging the each power supply device is V2, and a charging current value of the each power supply device is I1,

[Expression 1]

$$R1=(V2-V1)/I1;$$

and

calculating second resistance value R2 using Expression 2, wherein a voltage value of the each power supply device at a time T3 immediately before finishing charging the each power supply device is V3, and a voltage value at a time T4 immediately after finishing charging the each power supply device is V2,

[Expression 2]

$$R2=(V3-V4)/I1,$$

and

said grouping the one or more power supply devices comprises grouping one or more power supply devices out of the power supply devices each having a total value or an average value of the first resistance value and the second resistance value of the each power supply device which is within a predetermined range.

In a method of recycling the power supply device in accordance with another aspect of the present invention, in any of the above-mentioned aspects, said measuring the resistance values comprises: calculating a third resistance value R3 using Expression 3, wherein a voltage value of each power supply device at a time T5 before starting discharging the each power supply device is V5, a voltage value of the each power supply device at a time T6 immediately after starting discharging the each power supply device is V6, and a discharge current value of the each power supply device is I2,

[Expression 3]

$$R3=(V5-V6)/I2;$$

and

calculating a fourth resistance value R4 using Expression 4, wherein a voltage value of the each power supply device at a time T7 immediately before finishing discharging the each power supply device is V7, a current value of the each power supply device is I3, and a voltage value of the each power supply device at a time T8 immediately after finishing discharging the each power supply device is V8,

[Expression 4]

$$R4=(V8-V7)/I3,$$

and
said grouping the one or more power supply devices comprises grouping one or more power supply devices out of the power supply devices having a total value or an average value of the third resistance value and the fourth resistance value of the each power supply device is within a predetermined range.

In a method of recycling the power supply device in accordance with another aspect of the present invention, in any of the above-mentioned aspects, said measuring the resistance values comprises: calculating a first resistance value R1 using Expression 1, wherein a voltage value of each power supply device at a time T1 before starting charging the each power supply device is V1, a voltage value of the each power supply device at time T2 immediately after starting charging each power supply device is V2, and a current value of each power supply device is I1,

[Expression 1]

$$R1=(V2-V1)/I1;$$

calculating a second resistance value R2 using Expression 2, wherein a voltage value of the each power supply device at a time T3 immediately before finishing charging the each power supply device is V3, a voltage value of the each power supply device at a time T4 immediately after finishing charging the each power supply device is V4,

[Expression 2]

$$R2=(V3-V4)/I1;$$

calculating a third resistance value R3 using Expression 3, wherein a voltage value of the each power supply device at a time T5 before starting discharging the each power supply device is V5, a voltage value of the each power supply device at a time T6 immediately after starting discharging the each power supply device is V6, and a current value of the each power supply device is I2,

[Expression 3]

$$R3=(V5-V6)/I2;$$

and
calculating a fourth resistance value R4 using Expression 4, wherein a voltage value of the each power supply device at a time T7 immediately before finishing discharging the each power supply device is V7, a current value of the each power supply device is I3, and a voltage value of the each power supply device at a time T8 immediately after finishing discharging the each power supply device is V8,

[Expression 4]

$$R4=(V8-V7)/I3,$$

and
said grouping the one or more power supply devices comprises grouping one or more power supply devices out of the power supply devices each having a total value or an average value of the first resistance value, the second resistance value, the third resistance value, and the fourth resistance value of the each power supply device is within a predetermined range.

In a method of recycling the power supply device in accordance with another aspect of the present invention, in any of the above-mentioned aspects, the predetermined range is not greater than 5% in said grouping the one or more power supply devices.
In a method of recycling the power supply device in accordance with another aspect of the present invention, in any of the above-mentioned aspects, said grouping the one or more power supply devices comprises not reusing a battery block out of the plurality of the battery blocks which has a resistance value higher than a predetermined reference.
In a method of recycling the power supply device in accordance with another aspect of the present invention, in any of the above-mentioned aspects, said producing the new power supply device comprises constituting a new power supply device including a quantity of series connections or parallel connections of battery blocks accommodated in a housing of the new power supply device is different than an original power supply device.
In a method of recycling the power supply device in accordance with another aspect of the present invention, in any of the above-mentioned aspects, said producing the new power supply device comprises accommodating the plurality of battery blocks in a housing different from an original housing from which the battery blocks are taken out.
In a method of recycling the power supply device in accordance with another aspect of the present invention, in any of the above-mentioned aspects, the plurality of battery blocks accommodated in the housing of the power supply devices are connected with solder-free. By not using solder, the power supply device is easily disassembled, and damage or heat stress, which is caused by solder melting, can be avoided from applying to members such as a circuit board, advantageously.

In a method of recycling the power supply device in accordance with another aspect of the present invention, in any of the above-mentioned aspects, the plurality of battery blocks accommodated in the housing of the power supply devices are connect to the circuit board through a connector.

In a method of recycling the power supply device in accordance with another aspect of the present invention, in any of the above-mentioned aspects, each battery block further includes a thermistor thermally coupled with the plurality of secondary battery cells, and the thermistor is connected to the circuit board through a connector. Being thermally coupled with the secondary battery cell through a glue or the like, the thermistor is easily separated from the circuit board through the connector while remaining fixed to the secondary battery cell.

In a method of recycling the power supply device recycling method in accordance with another aspect of the present invention, in any of the above-mentioned aspects, each battery block is connected to the circuit board through a bus bar, and the bus bar is divided into a plurality of portions contacting respective electrical connection regions. The bus bar is easily bent by dividing, and contact resistance is reduced simultaneously. In other words, a bus bar made of a large plate hardly provides a sufficient contact area. However, the busbar divided increases a contact area.

In a method of recycling the power supply device in accordance with another aspect of the present invention, in any of the above-mentioned aspects, each battery block is fixed to the housing through a fixture. The fixture has a first surface and a second surface that are bent in an L-shape, the fixture including: a first connection mechanism provided on the first surface thereof, the first connection mechanism being connectable with a first battery block having a particular shape; and a second connection mechanism provided on the second surface thereof, the second connection mechanism being connectable with a second battery block having a different shape from the first battery block. Since the battery blocks having different shapes can be fixed to a common housing using a common fixture, reuse of the battery blocks, which are dismounted from the power supply device and have different specifications, can be promoted without necessity of preparing a dedicated housing.

In a method of recycling the power supply device recycling method in accordance with another aspect of the present invention, in any of the above-mentioned aspects, the power supply devices are useable for backup application in which large-capacity discharge is performed in a short period of time so as to power electrical equipment.

In a method of recycling the power supply device recycling method in accordance with another aspect of the present invention, in any of the above-mentioned aspects, the power supply devices are useable for backup application in which a discharge of 5C or more is performed for several minutes so as to power electrical equipment.

Hereinafter, exemplary embodiments of the present invention will be described based on the drawings. However, the exemplary embodiments described below each show a specific example of the technical thought of the present invention, and does not limit the present invention to below. Further, the present description does not intend to specify members, shown in the claim, to the members described in the exemplary embodiment. Especially, unless otherwise noted, dimensions, materials, and shapes of the components described in the exemplary embodiments, a relative arrangement therebetween, and the like intend not to limit the scope of the present invention, but merely illustrate the scope. Note that, sizes of members shown in the drawing, a positional relationship therebetween, or the like may be exaggerated to clarify the description. Furthermore, in the following description, like names or reference signs indicate like or equivalent members, and detailed description thereof will be omitted. Furthermore, each element constituting the present invention may be configured such that plural elements are constituted by the same members to serve the plurality of elements as one member, or a function of one member is shared by the plurality of elements vice versa.

The power supply device recycling method of the present invention can be used for a stationary type of power storage applications as a backup power supply for a server or power supply devices for household use, business offices, or factory. Further, the power supply device recycling method can be used for a driving power supply for vehicles, such as a hybrid car and an electric vehicle, or a driving power supply for an electric scooter, an electric cart, and an assisted bicycle. Furthermore, the power supply device recycling method can be used for a power supply for portable electrical equipment such as a walkie-talkie, an electric cleaner, and a power tool. Hereinafter, a recycling method of a power supply device, which is included in power supply devices used as a backup power supply for a server, will be described as one exemplary embodiment of the present invention.

Exemplary Embodiment 1

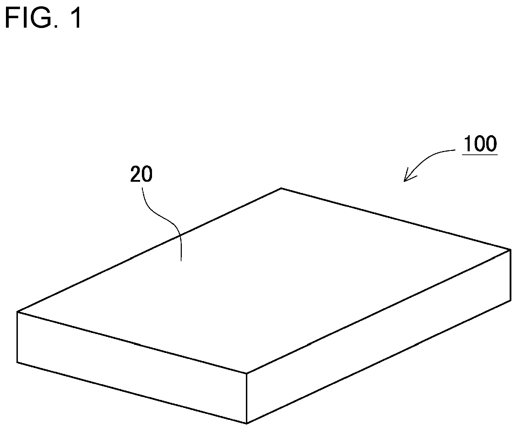

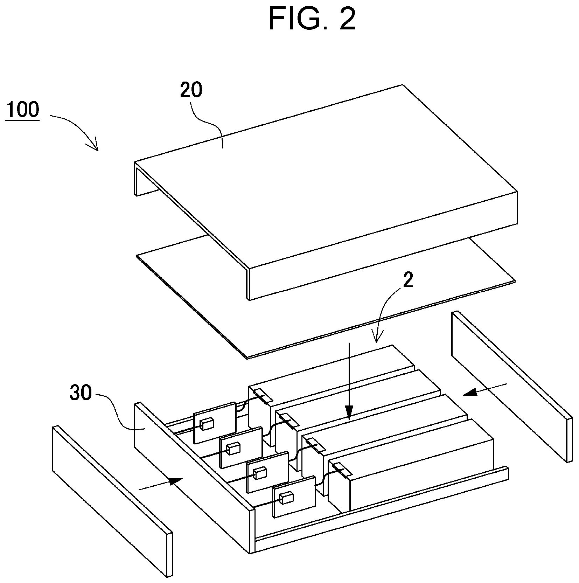

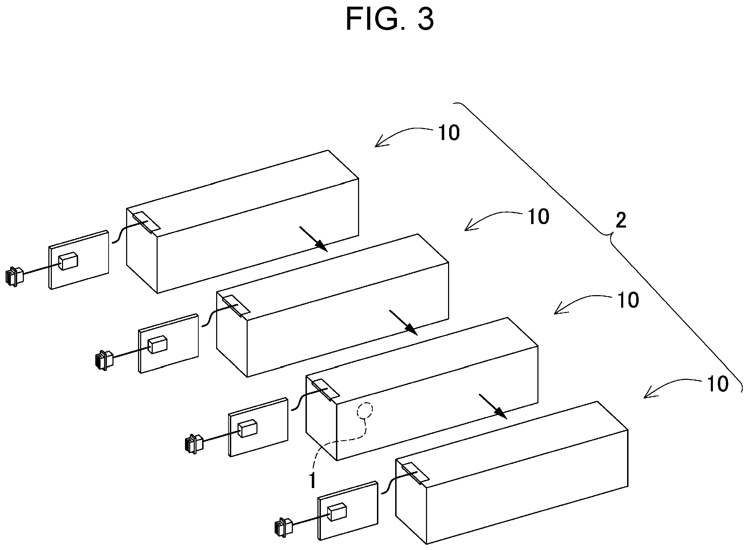

Power supply device 100 which is used in a method of recycling the power supply device in accordance with Exemplary Embodiment 1 of the present invention is shown in FIGS. 1-3. FIG. 1 is a perspective view of power supply device 100 in accordance with Embodiment 1. FIG. 2 is an exploded perspective view of power supply device 100 shown in FIG. 1. FIG. 3 is an exploded perspective view of battery module 2 shown FIG. 2 disassembled into battery blocks 10. Power supply device 100 shown in these figures includes housing 20 and battery module 2.

Housing 20

Housing 20 accommodates battery module 2 and circuit board 30 therein, and may have an optional shape. In the example of FIG. 1, the external shape of the housing is rectangular. Housing 20 has an accommodating space therein. For instance, as shown in FIG. 2, a divided case in which the accommodating space is vertically divided into two is employed. In the present invention, the housing is not limited to this configuration. The accommodating space may be horizontally divided into two, or may be divided into, e.g., three or more. A metal plate with stiffness and a resin with excellent insulation properties, such as polycarbonate or PC-ABS alloy, may be used to provide the housing. As shown in FIG. 2, an accommodating space for battery module 2 or the like is provided in housing 20.

Battery Module 2

As shown in FIG. 2, battery module 2 and circuit board 30 are accommodated in housing 20. Battery module 2 includes battery blocks 10, as shown in FIG. 3. In the example of FIG. 3, battery module 2 includes four battery blocks 10, but the number of battery blocks constituting the battery module is not limited to this. Three or less or five or more battery blocks may be used. Further, the number of battery modules accommodated in the housing is not limited to one. Two or more battery modules may be accommodated.

Battery Block 10

Each battery block 10 includes secondary battery cells 1. Battery block 10 may include a battery holder accommodating secondary battery cell 1 therein. The battery holder includes housing tubes each accommodating secondary battery cell 1 therein individually. The battery holder may be made of resin, such as polycarbonate, with excellent insulation properties. In the example of FIG. 3, each battery block 10 includes 56 secondary battery cells 1, but the number of the secondary battery cells constituting each battery block is not limited to this. The number may be chosen optionally. If the battery holder is common, battery block 10 may be reused more easily. In a part of battery blocks, the number of the secondary battery cells may be changed.

Secondary Battery Cell 1

Each secondary battery cell 1 includes a positive electrode and a negative electrode individually. The positive electrode and the negative electrode are provided preferably on one end surface of secondary battery cell 1. As secondary battery cell 1, known secondary batteries, such as a lithium-ion secondary battery, a nickel hydride battery, and a nickelcadmium battery, may be used, as necessary. As secondary battery cell 1, a rectangular or cylindrical secondary battery cell may be used. The examples shown in FIGS. 2 and 3 exemplarily show secondary battery cell 1 including a cylindrical outer can.

Each battery block 10 is connected to circuit board 30 through a lead plate. A charge/discharge circuit and a protection circuit may be mounted on circuit board 30. The charge/discharge circuit is configured to charge and discharge secondary battery cell 1, and the protection circuit monitors voltage and temperature of secondary battery cell 1 to shut down current when abnormality occurs.

Solder Free Connection

A connection between battery blocks 10 or a connection between battery block 10 and circuit board 30 is established without solder, i.e., in a solder-free connection method. Known connection methods may be used as necessary, i.e., a connector is provided at a tip end of a lead wire to be fitted and connected, and a lead plate is screwed, for example. By not using solder, disassembly is facilitated, and re-connection is performed more easily. This configuration allows a secondary battery to be easily reused. If solder is used in assembling or disassembling, damage, or heat stress, which is caused by solder melting, will likely to be applied to members, such as a circuit board, when the power supply device is disassembled and reconstructed. However, by not using solder, such damages are not applied, so that the reliability of each member can be improved advantageously.

Method of Recycling Power Supply Device

As the result that power supply device 100 is used for a certain period, it may be made difficult to satisfy the expected specification required for the power supply device, e.g., battery capacity falls due to aged deterioration. In this case, the power supply device needs to be replaced. In this case, conventionally, an old power supply device is disposed and replaced with a new power supply device. However, even if being an old one, the power supply device is recyclable for other applications. For instance, a backup power supply for a server typically requires high reliability, so that the required specification is likely to be high. On the other hand, for a power storage device for home use, a power supply device for a power tool, or the like, the specification can sufficiently satisfy practical use even if being lower. Accordingly, it can be considered that the secondary battery cell is reused as a power supply device for such applications with different specifications.

On the other hand, also in a power supply device for the same application, e.g., a backup power supply for a server, housing 20, circuit board 30, or a connector may still be usable even if the secondary battery cell is deteriorated. In this case, disposal of the power supply device which includes these usable members is inadvisable from the viewpoint of resource utilization. Accordingly, it can also be considered that only battery module 2 is replaced with a new one and peripheral members, such as the housing 20, are reused as they are.

The present disclosure is thus made to contemplate not disposing a power supply device deteriorated over time, but reusing usable members efficiently in usable field and application.

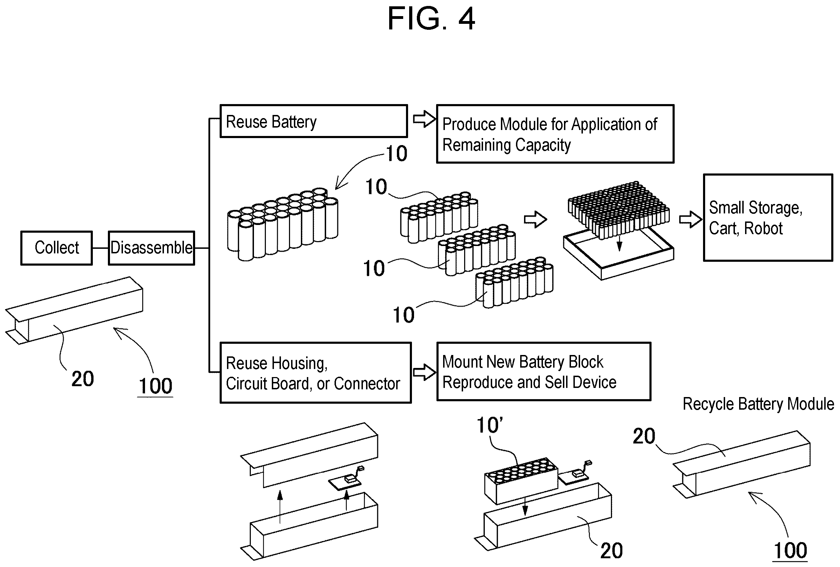

FIG. 4 shows a method of recycling a power supply device in accordance with an exemplary embodiment. As shown in this figure, power supply device 100 is disassembled and divided into (1) battery block 10 and (2) other parts. Power supply device 100 hardly satisfies a specification of a primary use as a result of primary-market use. Then, (1) battery block 10 is reconstructed to another battery module 2 and reused in a secondary market whose specification is lower than that of the primary market. For instance, when the primary use is a backup power supply for a server, the secondary market is a small storage battery, a power supply for electric cart or robot, or the like.

On the other hand, (2) other parts, other than battery block 10, are used to reconstruct battery module 2 of primary use, together with new battery block 10'. In this method, the secondary battery cell which is still usable in the other application may be utilized, and, the members, such as housing 20, may be used continuously in the same application.

Method of Recycling Power Supply Device with Different Specification

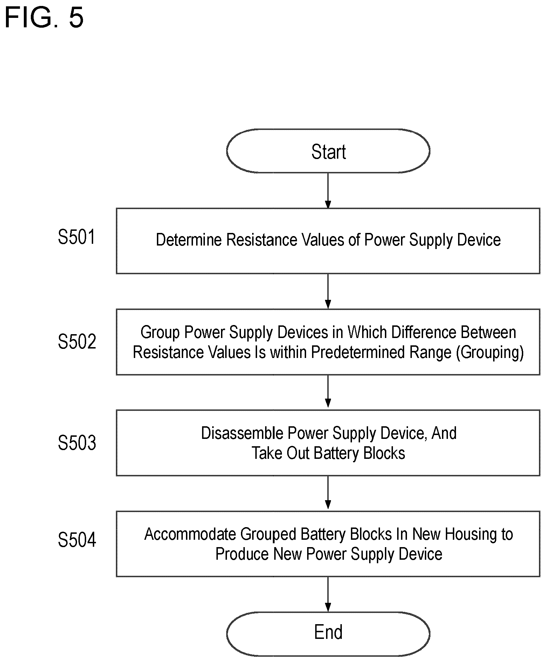

A method of recycling a power supply device with different specification will exemplarily be described with reference to the flowchart of FIG. 5, as a method of recycling the power supply device. A method in which power supply devices are disassembled to reproduce one or more power supply devices with different specifications will be described. First, in step S501, resistance values of power supply device 100 are measured. Power supply device 100 whose battery module 2 is detected to be deteriorated is charged or discharged for a predetermined time, and resistance values of the device are measured based on current values and voltage values before and after starting to charge or discharge the device and based on a voltage value before and after finishing to charge or discharge the device. The predetermined time for which the charge or the discharge is performed is a short period of time, preferably, not longer than 10 seconds. The charge or the discharge is performed for a short period of time, and reduces a tact time accordingly compared with a method of performing charge and discharge for several hours. This configuration enables efficient processing. The deterioration may be detected mechanically based on the number of times of use, a period of use, or the like of the battery, in addition to electrically detecting battery remaining capacity, SOC, or the like.

Next, in step S502, grouping is performed based on the resistance values of power supply devices 100. One or more power supply devices 100 in which differences between resistance values thereof are within a predetermined range are grouped. Further, power supply device 100 with resistance values are deteriorated to a predetermined value or less is determined to be not reusable, and disposed (detailed later).

Then, in step S503, power supply device 100 which is grouped is disassembled to take out battery blocks 10. Specifically, housing 20 of power supply device 100 is disassembled, and battery blocks 10 accommodated therein are taken out. For instance, battery module 2 is taken out and disassembled into battery blocks 10.

In step S504, battery blocks 10 which are grouped are accommodated in a new housing to produce new power supply device 100'. Only the required number of battery blocks 10 which are grouped may be taken out and accommodated in housing 20 to produce new power supply device 100'. A new power supply device including battery blocks 10 with the same resistance values are thus obtained.

The required specification of new power supply device 100' is lower than that of original power supply device 100. For instance, if original power supply device 100 is used for backup application in which large capacity discharge is performed in a short period of time, the required specification is too high for electrical equipment to be powered. For instance, a backup power supply for a server requires a high specification in which a discharge of 5C or more is performed for several minutes. Even if being difficult to satisfy such high specification, battery block 10 may sufficiently be usable for other applications. For instance, a small storage battery, an electric cart, a robot, or the like may require a specification in which a discharge not greater than 1C is performed. Even if being deteriorated, battery block 10 may thus be diverted to another power supply device with different specification. Thus, the secondary battery still usable for the other applications may be avoided from being disposed of, so that limited resources are utilized effectively.

Further, when the power supply device with different specification is produced, peripheral members such as housing 20 or circuit board 30 can be changed. In other words, new housing 20 or new circuit board 30 may be prepared, as necessary, independently from original power supply device 100. Thus, when being reproduced as new power supply device 100', the power supply device may be different from original power supply device 100 in a size, a shape, and a specification, thereby increasing its flexibility.

Method of Recycling Power Supply Device with Same Specification

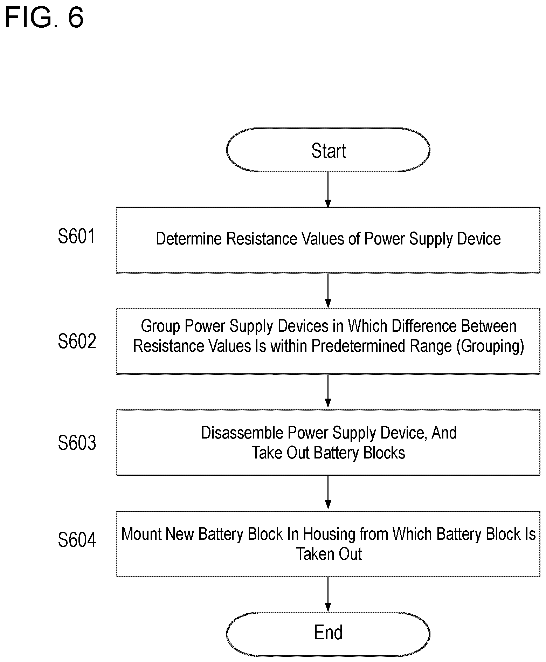

On the other hand, even when a power supply device with the same specification is reproduced, usable members may be reused. A method of recycling a power supply device with the same specification will be described with reference to the flowchart of FIG. 6, as an example of another method of recycling a power supply device. In this case, a method in which power supply devices are disassembled to reproduce one or more power supply devices with the same specification will be described. First, in step S601, resistance values of the power supply device are measured. Herein, similarly to step S501 shown in FIG. 5 mentioned above, power supply device 100 including battery module 2 detected to be deteriorated is charged or discharged for a predetermined time, and resistance values are measured based on current values and voltage values before and after starting charging or discharging the devices and based on voltage values before and after finishing to charge or discharge the devices.

Next, in step S602, grouping is performed based on the resistance values. Similarly to step S502 mentioned above, one or more power supply devices with differences between the resistance values which are within a predetermined range are grouped. Then, in step S603, the power supply devices which are grouped are disassembled, and battery blocks 10 and circuit board 30 accommodated therein are taken out. This process is the same as S503 mentioned above. In other words, the processes up to this point are the same as steps S501-S503 shown in FIG. 5 which are mentioned above.

Next, in step S604, new battery blocks 10 are installed in housing 20 from which battery blocks 10 have already been taken out, and connected to circuit board 30. Here, new battery blocks 10 are prepared for replacement. In this case, still usable peripheral members, such as circuit board 30 and the connector, are used as they are, i.e., only the deteriorated battery blocks are replaced, and the peripheral members are connected to the new battery blocks. The new battery blocks are accommodated in housing 20, thereby recycling power supply device 100.

On the other hand, the battery blocks which have been taken out in step S602 may be used for another power supply device based on a result of the grouping. In other words, similarly to step S502 mentioned above, one or more power supply blocks with differences between the resistance values which are within a predetermined range are grouped, and the grouped battery blocks are reused as a power supply device usable for the other applications.

Battery blocks requiring high specification has a short lifetime, e.g., three years to five years, whereas peripheral equipment, such as housing 20 and circuit board 30, has a longer lifetime, e.g., ten years, than the battery block. In other words, the members other than the battery block are often usable. Therefore, if the usable members are reused while only the battery block is replaced, the peripheral members are prevented from being disposed of, so that materials may be utilized efficiently. Further, as mentioned above, the deteriorated battery block is also usable for the other application requiring low specification. Therefore, the deteriorated battery block may be reused as a power supply device used for the other applications, thereby reducing waste. In this way, the method of recycling a power supply device with different specification and the method of recycling a power supply device with the same specification are combined to reduce disposal of members, similarly to FIG. 4, and promote reuse in usable applications. As a result, disposal cost is reduced, and resources are utilized effectively.

Change of the Number of Series Connections and the Number of Parallel Connections

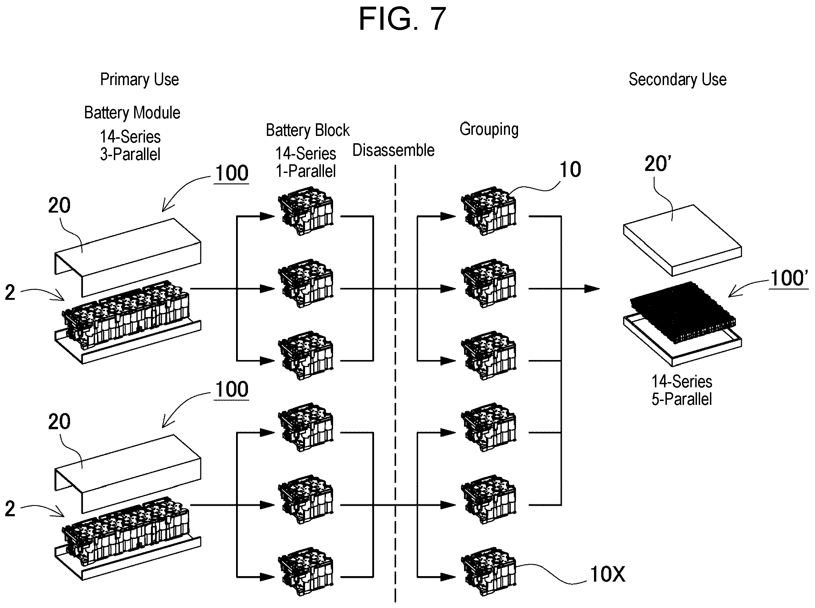

In the case where battery blocks 10 are reused in another power supply device, the number of series connections and the number of parallel connections of battery blocks 10 may be changed from the original power supply device. For instance, as shown in the left side of FIG. 7, it is exemplarily assumed that, in original power supply device 100 used primarily, three battery blocks 10 are connected in parallel to one another to constitute battery module 2. Each battery block 10 includes 14 secondary battery cells 1 connected in series to one another. Each power supply device 100 includes secondary battery cells 1 connected such that 14 cells are connected in series to one another. Two or more power supply devices 100, mentioned above, are prepared. Each device is disassembled to take out battery blocks 10, and grouping the blocks based on the resistance values. Further, according to a result of the grouping, battery block 10X with the resistance value which is a predetermined value or more due to deterioration is determined to be not reusable, and disposed.

Then, the number of series connections or the number of parallel connections is changed when a power supply device for the other application is newly produced. For instance, as shown in the right side of FIG. 7, in new power supply device 100' which is used secondarily, the number of battery blocks 10 which are to be connected and accommodated in housing 20' is not three but if five. As a result, the number of parallel connections is changed from three to five while the number of series connections is maintained to 14. The increasing of the number of parallel connections reduces a load to each battery block, so that, even if being deteriorated by aging, the battery block may be used with high reliability. In the example of FIG. 7, the number of series connections is the same, but the present invention is not limited to this configuration. The number of series connections may be changed. For instance, it is assumed that each battery block includes secondary battery cells connected such that 7 cells are connected in series to one another in each assembly two assembly are connected parallel to each other. In original power supply device 100 which is used primarily, three battery blocks are connected to constitute battery module 2 in which secondary battery cells are connected such that 21 cells are connected in series to one another to constitute each assembly, and two assemblies are connected parallel to each other, whereas in new power supply device 100' which is used secondarily, five battery blocks may be connected to constitute battery module 2 in which secondary battery cells are connected such that 35 cells are connected in series to one another to constitute each assembly and two assemblies are connected parallel to each other.

Grouping

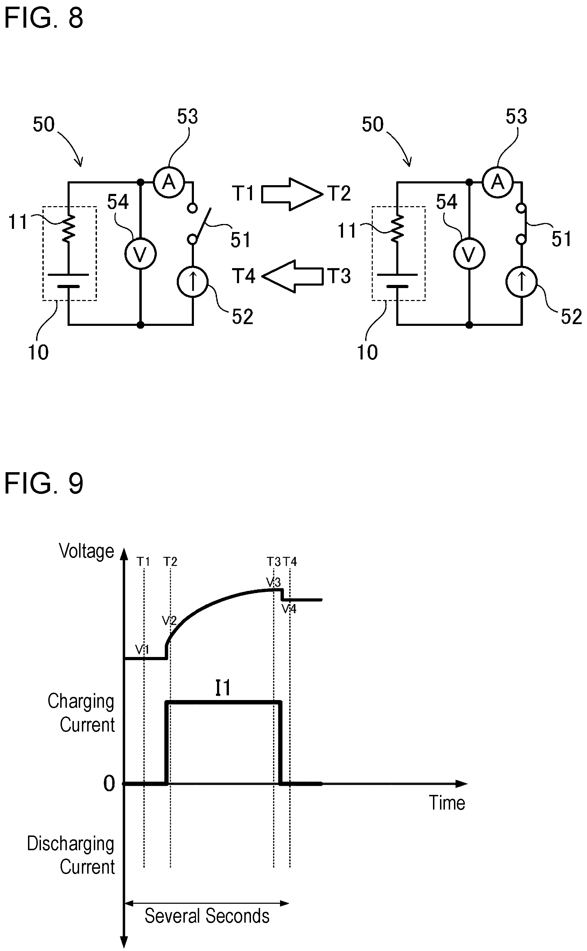

A method of measuring resistance values of battery block 10 for grouping will be described below with referring to FIGS. 8-13. First, as an example, a method of measuring the resistance values of battery block 10 discharged for a short period of time will be described with referring to FIGS. 8 and 9.

Method of Measuring Resistance Values Based on Charging Current

Each battery block 10 which have been disassembled is connected to resistance measurement circuit 50 shown in FIG. 8. Resistance measurement circuit 50 includes first switch 51, constant current source 52, ammeter 53, and voltmeter 54. This figure shows resistor 11 of battery block 10 virtually. Resistance measurement circuit 50 allows constant current source 52 to charge battery block 10 with constant current I1 for a short period of time, and measure a change in the voltage, as shown in a graph of FIG. 9. The charging is performed for several seconds. The charging is performed for a time preferably not longer than 30 seconds, more preferably, not longer than 10 seconds. The charging for a short period of time provides efficient processing compared with a conventional method in which a battery is completely discharged after being fully charged. Especially, a tact time can also be shortened to promote reuse of a lot of battery blocks.

First resistance value R1 is calculated using Expression 1 where V1 is a voltage value of battery block 10 at time T1 before the charge is started, V2 is a voltage value at time T2 immediately after the charge is started, and I1 is a charging current value,

[Expression 1]

$$R1=(V2-V1)/I1.$$

Second resistance value R2 is calculated using Expression 2 where V3 is a voltage value of each battery block 10 at time T3 immediately before the charging is finished, V4 is a voltage value at time T4 immediately after the charging is finished,

[Expression 2]

$$R2=(V3-V4)/I1.$$

First resistance value R1 and second resistance value R2 are thus measured. The resistance values thus obtained are used to perform grouping. For the grouping, one or more battery blocks 10 in which a total value or an average value of the first resistance value and the second resistance value of each battery block 10 is within a predetermined range are grouped. The range of variations for the grouping may be not greater than 5%, preferably not greater than 3%.

Method of Measuring Resistance Values Based on Discharge Current

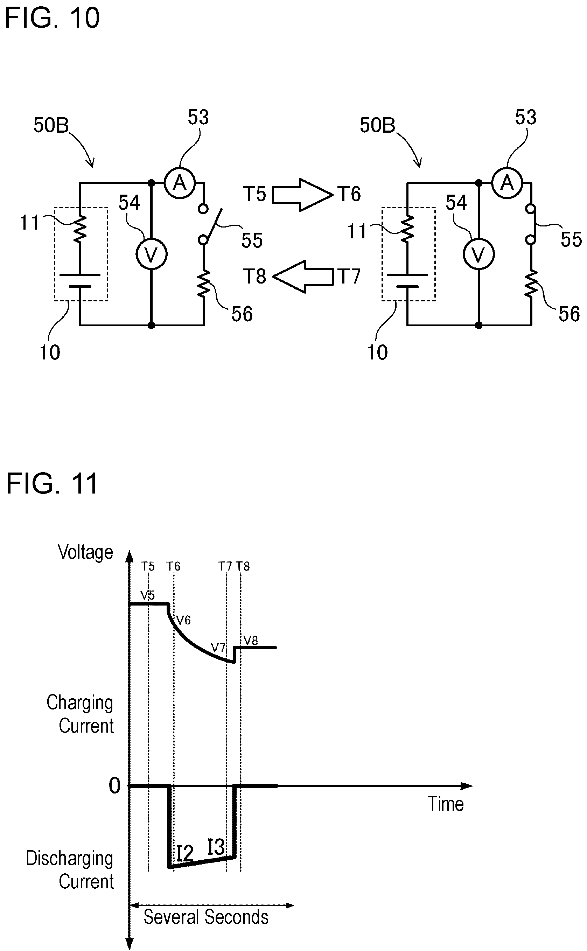

The method of measuring resistance values based on a charging current value has been described above as an example, but a method of measuring resistance values is not limited to this. Another method may be utilized. For instance, the resistance values may be measured based on discharge current. Such an example will be described below with referring to FIGS. 10 and 11. Battery block 10 is connected to resistance measurement circuit 50B of FIG. 10. Resistance measurement circuit 50B includes second switch 55, load resistor 56, ammeter 53, and voltmeter 54. Resistance measurement circuit 50B discharges battery block 10 for a short period of time and a change in the voltage is measured, as shown in the graph of FIG. 11. The discharging is performed for several seconds. The discharging is performed for a time preferably not longer than 30 seconds, more preferably, not longer than 10 seconds. The discharging for a short period of time provides efficient processing compared with a method in which a battery is completely discharged.

Third resistance value R3 is calculated using Expression 3 where V5 is a voltage value of battery block 10 at time T5 before the discharge is started, V6 is a voltage value at time T6 immediately after the discharge is started, and I2 is a discharge current value,

[Expression 3]

$$R3=(V5-V6)/I2.$$

Fourth resistance value R4 is calculated using Expression 4 where V7 is a voltage value of each battery block 10 at time T7 immediately before the discharge is finished, I3 is a discharge current value, and V8 is a voltage value at time T8 immediately after the discharge

is finished,

[Expression 4]

$$R4=(V8-V7)/I3.$$

Third resistance R3 and fourth resistance value R4 are thus measured. T6-T5 and T8-T7 may be a short period of time, and the resistance values are used to perform grouping. For the grouping, one or more battery blocks 10 in which a total value or an average value of the third resistance value and the fourth resistance value of each battery block 10 is within a predetermined range are grouped. The range of variations in the grouping may be not greater than 5%, preferably not greater than 3%.

Method of Measuring Resistance Values Based on Charging Current and Discharge Current

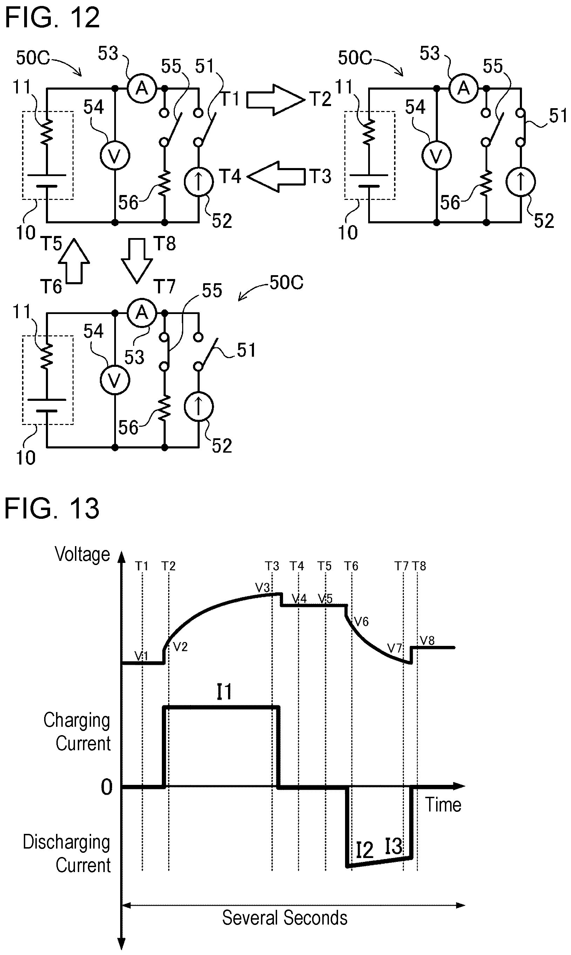

Battery blocks 10 may be charged and discharged to measure resistance values. Such an example will be described below with reference to FIGS. 12 and 13. Battery block 10 is connected to resistance measurement circuit 50C shown in FIG. 12. Resistance measurement circuit 50C includes first switch 51, constant current source 52, load resistor 56, second switch 55, ammeter 53, and voltmeter 54. Resistance measurement circuit 50C charges and discharges battery block 10 for a short period of time, and a change in the voltage is measured, as shown in the graph of FIG. 13. The charging and discharging are performed for several seconds. The charging and the discharging are performed for a time preferably not longer than 30 seconds, more preferably, not longer than 10 seconds. The charging and discharging for a short period of time provides efficient processing compared with a method in which a battery is almost fully charged or completely discharged.

First resistance value R1 is calculated using Expression 1 where V1 is a voltage value of each battery block 10 at time T1 before the charge is started, V2 is a voltage value at time T2 immediately after the charge is started, and I1 is a charging current value,

[Expression 1]

$$R1=(V2-V1)/I1.$$

Second resistance value R2 is calculated using Expression 2 where V3 is a voltage value of each battery block 10 at time T3 immediately before the charge is finished, V4 is a voltage value at time T4 immediately after the charge is finished,

[Expression 2]

$$R2=(V3-V4)/I1.$$

Third resistance value R3 is calculated using Expression 3 where V5 is a voltage value of each battery block 10 at time T5 before the discharge is started, V6 is a voltage value at time T6 immediately after the discharge is started, and I2 is a discharge current value,

[Expression 3]

$$R3=(V5-V6)/I2.$$

Fourth resistance value R4 is calculated using Expression 4 where V7 is a voltage value of each battery block 10 at time T7 immediately before the discharge is finished, I3 is a discharge current value, and V8 is a voltage value at time T8 immediately after the discharge is finished,

[Expression 4]

$$R4=(V8-V7)/I3.$$

First resistance value R1, second resistance value R2, third resistance value R3, and fourth resistance value R4 are thus measured. T2-T1, T4-T3, T6-T5, and T8-T7 may be a short period of time, and the resistance values are used to perform grouping. For the grouping, one or more battery blocks 10 in which a total value or an average value of the first resistance value, the second resistance value, the third resistance value, and the fourth resistance value of each battery block 10 is within a predetermined range are grouped. The range of variations in the grouping may be not greater than 5%, preferably, not greater than 3%.

While the discharging is performed after the charging in the example of FIG. 13, the charging may be performed after the discharging. Even if the battery block is fully charged, resistance values at the time of charge and discharge may be measured advantageously.

In the grouping, battery block 10 with a resistance value higher than a predetermined reference value is determined to be deteriorated intensely, and is not reused. The predetermined reference value may be, e.g., a resistance value larger than an initial resistance value by more than 30%.

The above-mentioned example describes the methods of measuring the resistance values while battery module 2 has been taken out from housing 20 and disassembled into battery blocks 10. However, the present invention is not limited to these methods. For instance, the resistance values of each battery block may be measured while battery module 2 is accommodated in the housing without being disassembled into battery blocks. For instance, the battery module may include a jumper pin configured to temporarily disconnect the battery block, or may include a terminal configured to charge and discharge each battery block from the outside of the housing. These configurations allow the resistance values to be measured without physically disassembling the device into the battery blocks.

To reuse such a power supply device efficiently, it becomes important to facilitate disassembly and assembly of power supply device 100 and secure reliability of electric connections in assembling. A practical configuration including these will be detailed below.

Connector

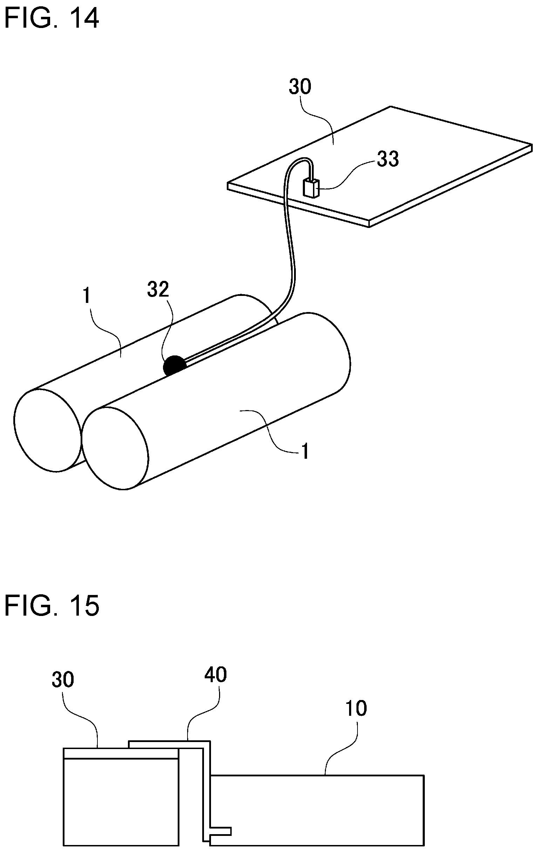

In power supply device 100, battery blocks 10 accommodated inside each housing 20 are connected to circuit board 30 through a connector. As shown in FIG. 14, each battery block 10 includes thermistor 32 thermally coupled with a secondary battery. Thermistor 32 is connected to circuit board 30 through thermistor connector 33. This configuration allows thermistor 32 to be easily separated from circuit board 30 through thermistor connector 33 while thermistor 32 is fixed to the secondary battery and thermally coupled with the secondary battery with, e.g., a glue.

In other words, a glue used to enhance a thermal coupling between thermistor 32 and secondary battery cell 1 hardly allows thermistor 32 to be separated from secondary battery cell 1. This may cause a trouble in disassembling battery block 10. Thermistor connector 33 used as a connection part between thermistor 32 and circuit board 30, which serves as a connection point of thermistor 32, causes the connection part to be detachable. Thus, thermistor 32 may be reused without being separated from secondary battery cell 1, facilitating reuse of battery block 10.

Bus Bar 40

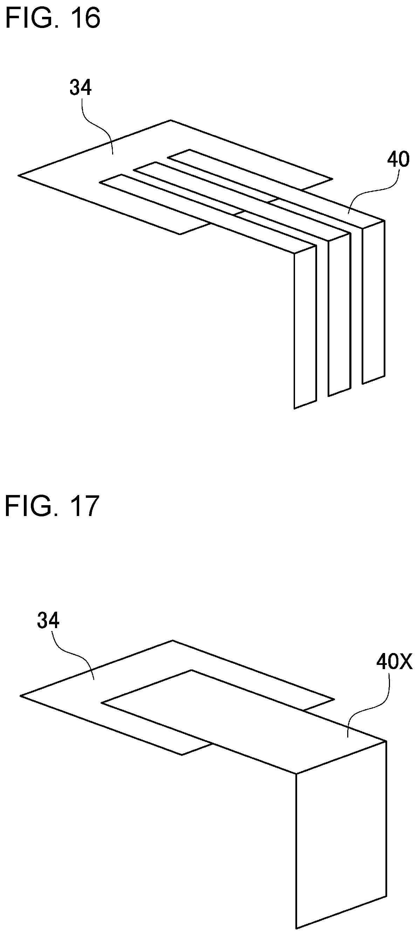

As shown in FIG. 15, battery block 10 is connected to circuit board 30 through bus bar 40. As shown in FIG. 16, bus bar 40 has a portion contacting an electrical connection region may be divided into two or more portions. This configuration allows bus bar 40 to be flexible by the dividing, and reduces contact resistance between bus bar 40 and connection region 34. In other words, as shown in FIG. 17, bus bar 40X made of a large plate hardly secure a contact area between bus bar 40X and connection region 34. On the other hand, divided bus bar 40 increases the contact area. Thick bus bar 40 is inflexible. But even thick bus bar 40 divided is flexible.

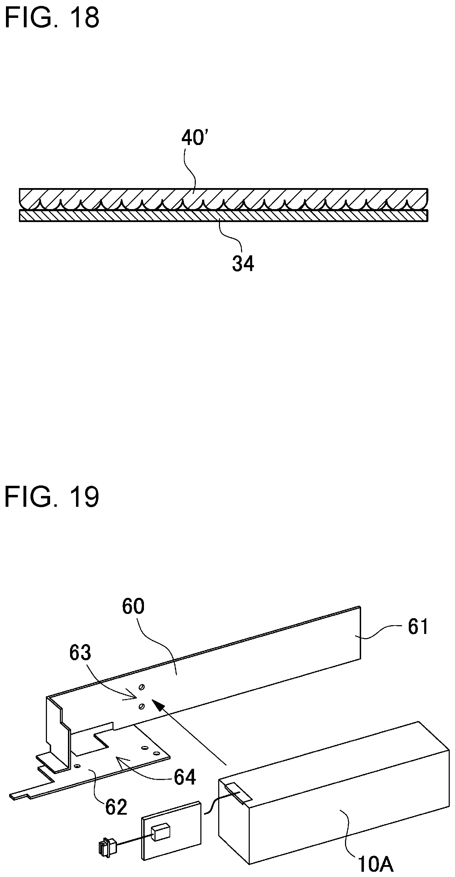

As shown in the cross-sectional view of FIG. 18, bus bar 40' has an uneven surface contacting connection region 34. This configuration stabilizes a contact resistance.

The above configurations prevent a contact failure in an electrical connection portion, degradation of a metal terminal due to its oxidization, or the like, when a new power supply device to be used secondarily, is produced, thereby improving the reliability of electrical connection.

Fixture 60

Battery blocks 10 used for various kinds of power supply devices 100 preferably have common shapes. Thus, common battery block 10 may easily be utilized when power supply device 100 is reassembled to power supply device 100' for different application.

However, the battery blocks may hardly be common in all the power supply devices. Further, there is a risk that battery blocks having different shapes are mixed therein. Therefore, even battery blocks having different shapes may be matched while the same housing is used. Accordingly, fixture 60 may be added to power supply device 100 such that battery blocks 10 having different shapes are fixed in common housing 20.

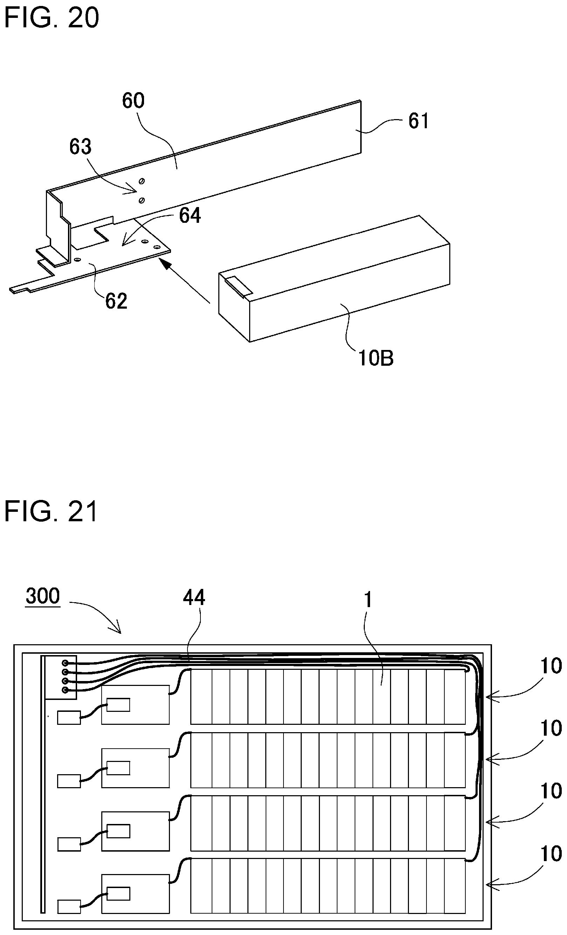

To fix battery block 10 in housing 20, fixture 60 includes two connection interfaces different from each other. As an example, in power supply device 100 shown in FIG. 2, each battery block 10 is fixed to housing 20 through fixture 60 having an L-shape. As shown in FIGS. 19 and 20, fixture 60 are bent in an L-shape and has first surface 61 and second surface 62. First connection mechanism 63 and second connection mechanism 64 for fixing first battery block 10A and second battery block 10B having different shapes to first surface 61 and second surface 62 are provided on first surface 61 and second surface 62, respectively.

As shown in FIG. 19, first connection mechanism 63 connectable with first battery block 10A with a particular shape is provided on first surface 61 of fixture 60. As shown in FIG. 20, second connection mechanism 64 connectable with second battery block 10B with a shape different from first battery block 10A is provided on second surface 62. First connection mechanisms 63 and second connection mechanism 64 function as a fixing mechanism matching a battery block with a different shape. For instance, in the case of screw connection, positions and sizes of threaded holes and the number of the threaded holes are designed according to the battery block. Further, in the case of fitting connection, a fitting structure is formed so as to be matched to a fitting structure on each battery block side. This configuration allows battery blocks with different shapes to be fixed to common housing 20 with connection mechanisms provided in different portions of common fixture 60. This configuration facilitates reuse of battery blocks with different specifications, which are dismounted from power supply device 100, without preparing a housing dedicated for each battery block. Fixture 60 may be an angle steel obtained by bending a metal plate.

Alternatively, two or more kinds of fixtures having different shapes may be prepared. For instance, a second fixture matching a third battery block and a fourth battery block may be prepared. The third battery block and the fourth battery block have shapes different from the first battery block and the second battery block. Such a dedicated fixture depending on a shape of a battery block allows battery blocks with different shapes to be accommodated in a common housing. Further, the example of FIGS. 19 and 20 show a configuration in which each of first connection mechanism 63 matching first battery block 10A and second connection mechanism 64 matching second battery block 10B are provided in a corresponding one of the two different surfaces, but the configuration is not limited to this. Fixture 60 may further include a third connection surface configured to be connected with the third battery block or a third connection surface configured to be connected with the fourth battery block.

Configuration Capable of Dismounting Battery Block

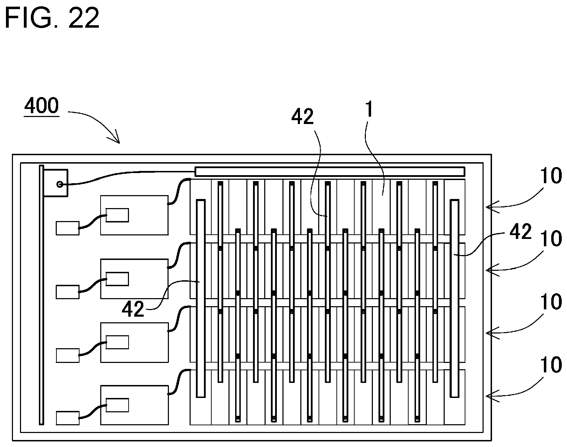

Power supply device 100 may be configured such that only a deteriorated battery block is replaced. The device may have a connection system in which only a deteriorated battery block is easily replaced. As an example, the horizontal cross-sectional view of Fig. 21 shows power supply device 300 of Example 3, and the horizontal cross-sectional view of Fig. 22 shows power supply device 400 of a comparative example. In the power supply devices shown in these figures, four battery blocks 10 are connected in parallel to one another, i.e., secondary battery cells 1 are connected in 14 series 4 parallels. In power supply device 400 of the comparative example shown in Fig. 22, an interconnection between battery blocks 10 is established such that each battery block 10 is connected to the other battery blocks 10 with inter-block bus bar 42. This configuration may cause a trouble in dismounting work. In other words, when particular battery block 10 is dismounted, all inter-block bus bars 42 are removed. Accordingly, in power supply device 300 of Example 3 shown in Fig. 21, an output terminal of each battery block 10 is collected to inter-block bus bar 42 from each battery block 10 through lead wire 44. Further, voltage between battery blocks 10 is transmitted by communication through a control board of each battery block 10 and monitored. This configuration allows particular battery block 10 to be easily dismounted due to no connection between battery blocks 10.

INDUSTRIAL APPLICABILITY

The power supply device recycling method in accordance with the present invention can be used suitably as a backup power supply for a server, a power supply for a walkie-talkie, or a power supply of portable electrical equipment, such as an electric cleaner and a power tool. Further, the power supply device recycling method can also be used suitably in other applications such as a power supply device for moving vehicles such as an assistant bicycle and an electric cart.

REFERENCE MARKS IN THE DRAWINGS

| 100, | 300, 400 power supply device |
|---|---|
| 100' | new power supply device |
| 1 | secondary battery cell |
| 2 | battery module |
| 10 | battery block |
| 10A | first battery block |
| 10B | second battery block |
| 10' | new battery block |
| 10X | deteriorated battery block |
| 11 | resistor |
| 20, 20' | housing |
| 30 | circuit board |
| 32 | thermistor |
| 33 | thermistor connector |
| 34 | connection region |
| 40, 40', | 40X bus bar |
| 42 | inter-block bus bar |
| 44 | lead wire |
| 50, | 50B, 50C resistance measurement circuit |
| 51 | first switch |
| 52 | constant current source |
| 53 | ammeter |
| 54 | voltmeter |
| 55 | second switch |
| 56 | load resistor |
| 60 | fixture |
| 61 | first face |
| 62 | second face |

**Claims**

1.  A method of recycling power supply devices, each of the power supply devices including a plurality of battery blocks, a circuit board, and a housing accommodating the plurality of battery blocks and the circuit board therein, each of the plurality of battery blocks including a plurality of secondary battery cells, the method comprising:

    measuring resistance values of the power supply devices based on current values and voltage values of the power supply devices before and after starting one of charging and discharging of the power supply devices for a predetermined time not longer than 10 seconds and based on current values and voltage values the power supply devices after finishing of one of charging and discharging of the power supply devices; grouping one or more power supply devices out of the power supply devices, the one or more power supply devices each having a difference between the resistance values which is within a predetermined range;

separating the housing, the circuit board, and the plurality of battery blocks from one another by disassembling the one or more power supply devices; and

reproducing, according to a result of said grouping, a power supply device by:

producing a new power supply device by accommodating the plurality of battery blocks in a new housing; or

reproducing a power supply device by combining a new battery block with the separated housing and the separated circuit board.

2. The method according to claim 1, wherein

said measuring the resistance values comprises:

calculating a first resistance value R1 using Expression 1, wherein a voltage value of each power supply device at a time T1 before starting charging the each power supply device is V1, a voltage value of the each power supply device at a time T2 immediately after staring charging the each power supply device is V2, and a charging current value of the each power supply device is I1,

[Expression 1]

$$R1=(V2-V1)/I1;$$

and

calculating second resistance value R2 using Expression 2, wherein a voltage value of the each power supply device at a time T3 immediately before finishing charging the each power supply device is V3, and a voltage value at a time T4 immediately after finishing charging the each power supply device is V2,

[Expression 2]

$$R2=(V3-V4)/I1,$$

and

said grouping the one or more power supply devices comprises grouping one or more power supply devices out of the power supply devices each having a total value or an average value of the first resistance value and the second resistance value of the each power supply device which is within a predetermined range.

3. The method according to claim 1, wherein

said measuring the resistance values comprises:

calculating a third resistance value R3 using Expression 3, wherein a voltage value of each power supply device at a time T5 before starting discharging the each power supply device is V5, a voltage value of the each power supply device at a time T6 immediately after starting discharging the each power supply device is V6, and a discharge current value of the each power supply device is I2,

[Expression 3]

$$R3=(V5-V6)/I2;$$

and

calculating a fourth resistance value R4 using Expression 4, wherein a voltage value of the each power supply device at a time T7 immediately before finishing discharging the each power supply device is V7, a current value of the each power supply device is I3, and a voltage value of the each power supply device at a time T8 immediately after finishing discharging the each power supply device is V8,

[Expression 4]

$$R4=(V8-V7)/I3,$$

and

said grouping the one or more power supply devices comprises grouping one or more power supply devices out of the power supply devices having a total value or an average value of the third resistance value and the fourth resistance value of the each power supply device is within a predetermined range.

4. The method according to claim 1, wherein

said measuring the resistance values comprises:

calculating a first resistance value R1 using Expression 1, wherein a voltage value of each power supply device at a time T1 before starting charging the each power supply device is V1, a voltage value of the each power supply device at time T2 immediately after starting charging each power supply device is V2, and a current value of each power supply device is I1,

[Expression 1]

$$R1=(V2-V1)/I1;$$

calculating a second resistance value R2 using Expression 2, wherein a voltage value of the each power supply device at a time T3 immediately before finishing charging the each power supply device is V3, a voltage value of the each power supply device at a time T4 immediately after finishing charging the each power supply device is V4,

[Expression 2]

$$R2=(V3-V4)/I1;$$

calculating a third resistance value R3 using Expression 3, wherein a voltage value of the each power supply device at a time T5 before starting discharging the each power supply device is V5, a voltage value of the each power supply device at a time T6 immediately after starting discharging the each power supply device is V6, and a current value of the each power supply device is I2,

[Expression 3]

$$R3=(V5-V6)/I2;$$

and
calculating a fourth resistance value R4 using Expression 4, wherein a voltage value of the each power supply device at a time T7 immediately before finishing discharging the each power supply device is V7, a current value of the each power supply device is I3, and a voltage value of the each power supply device at a time T8 immediately after finishing discharging the each power supply device is V8,

[Expression 4]

$$R4=(V8-V7)/I3,$$

and

said grouping the one or more power supply devices comprises grouping one or more power supply devices out of the power supply devices each having a total value or an average value of the first resistance value, the second resistance value, the third resistance value, and the fourth resistance value of the each power supply device is within a predetermined range.

5. The method according to any one of claims 1 to 4, wherein the predetermined range is not greater than 5% in said grouping the one or more power supply devices.

6. The method according to any one of claims 1 to 4, wherein said grouping the one or more power supply devices comprises not reusing a battery block out of the plurality of the battery blocks which has a resistance value higher than a predetermined reference.

7. The method according to any one of claims 1 to 4, wherein said producing the new power supply device comprises constituting a new power supply device including a quantity of series connections or parallel connections of battery blocks accommodated in a housing of the new power supply device is different than an original power supply device.

8. The method according to any one of claims 1 to 4, wherein said producing the new power supply device comprises accommodating the plurality of battery blocks in a housing different from an original housing from which the battery blocks are taken out.

9. The method according to any one of claims 1 to 4, wherein the plurality of battery blocks accommodated in the housing of the power supply devices are connected with solder-free.

10. The method according to any one of claims 1 to 4, wherein the plurality of battery blocks accommodated in the housing of the power supply devices are connect to the circuit board through a connector.

11. The method according to claim 10, wherein

each battery block further includes a thermistor thermally coupled with the plurality of secondary battery cells, and
the thermistor is connected to the circuit board through a connector.

12. The method according to any one of claims 1 to 4, wherein

each battery block is connected to the circuit board through a bus bar, and
the bus bar is divided into a plurality of portions contacting respective electrical connection regions.

13. The method according to any one of claims 1 to 4, wherein

each battery block is fixed to the housing through a fixture, and
the fixture has a first surface and a second surface that are bent in an L-shape, the fixture including:

a first connection mechanism provided on the first surface thereof, the first connection mechanism being connectable with a first battery block having a particular shape; and
a second connection mechanism provided on the second surface thereof, the second connection mechanism being connectable with a second battery block having a different shape from the first battery block.

14. The method according to any one of claims 1 to 4, wherein the power supply devices are useable for backup application in which large-capacity discharge is performed in a short period of time so as to power electrical equipment.

15. The method according to claim 14, wherein the power supply devices are useable for backup application in which a discharge of 5C or more is performed for several minutes so as to power electrical equipment.

FIG. 1

# FIG. 2

# FIG. 3

EP 4 597 681 A1

# FIG. 4

Collect → Disassemble → Reuse Battery → Produce Module for Application of Remaining Capacity

Reuse Housing, Circuit Board, or Connector → Mount New Battery Block Reproduce and Sell Device

Small Storage, Cart, Robot

Recycle Battery Module

10
10
10
10
10
20
100
10'
20
100

EP 4 597 681 A1

FIG. 5

```
                    ┌──────────────────┐
                    │      Start       │
                    └──────────────────┘
                             │
                             ▼
S501      ┌─────────────────────────────────────────────┐
          │  Determine Resistance Values of Power Supply Device  │
          └─────────────────────────────────────────────┘
                             │
                             ▼
S502      ┌─────────────────────────────────────────────┐
          │  Group Power Supply Devices in Which Difference Between  │
          │  Resistance Values Is within Predetermined Range (Grouping)  │
          └─────────────────────────────────────────────┘
                             │
                             ▼
S503      ┌─────────────────────────────────────────────┐
          │        Disassemble Power Supply Device, And         │
          │             Take Out Battery Blocks                 │
          └─────────────────────────────────────────────┘
                             │
                             ▼
S504      ┌─────────────────────────────────────────────┐
          │  Accommodate Grouped Battery Blocks In New Housing to  │
          │         Produce New Power Supply Device             │
          └─────────────────────────────────────────────┘
                             │
                             ▼
                    ┌──────────────────┐
                    │       End        │
                    └──────────────────┘
```

# FIG. 6

```
                          ┌─────────────────┐
                          │      Start       │
                          └─────────────────┘
                                   │
                                   ▼
S601        ┌──────────────────────────────────────────────────┐
            │     Determine Resistance Values of Power Supply Device     │
            └──────────────────────────────────────────────────┘
                                   │
                                   ▼
S602        ┌──────────────────────────────────────────────────┐
            │  Group Power Supply Devices in Which Difference Between  │
            │  Resistance Values Is within Predetermined Range (Grouping)  │
            └──────────────────────────────────────────────────┘
                                   │
                                   ▼
S603        ┌──────────────────────────────────────────────────┐
            │          Disassemble Power Supply Device, And        │
            │               Take Out Battery Blocks               │
            └──────────────────────────────────────────────────┘
                                   │
                                   ▼
S604        ┌──────────────────────────────────────────────────┐
            │  Mount New Battery Block In Housing from Which Battery Block Is  │
            │                    Taken Out                      │
            └──────────────────────────────────────────────────┘
                                   │
                                   ▼
                          ┌─────────────────┐
                          │       End        │
                          └─────────────────┘
```

# FIG. 7

Primary Use

Battery Module
14-Series
3-Parallel

Battery Block
14-Series
1-Parallel    Disassemble

Grouping

Secondary Use

14-Series
5-Parallel

FIG. 8

FIG. 9

FIG. 10

FIG. 11

FIG. 12

FIG. 13

FIG. 14

FIG. 15

FIG. 16

34

40

FIG. 17

34

40X

FIG. 18

FIG. 19

FIG. 20

FIG. 21

FIG. 22

## INTERNATIONAL SEARCH REPORT

International application No.

**PCT/JP2023/028287**

### A. CLASSIFICATION OF SUBJECT MATTER

*H01M 10/42*(2006.01)i; *H01M 10/48*(2006.01)i; *H01M 50/202*(2021.01)i; *H01M 50/204*(2021.01)i;
*H01M 50/247*(2021.01)i; *H01M 50/249*(2021.01)i; *H01M 50/251*(2021.01)i; *H01M 50/284*(2021.01)i; *H02J 7/00*(2006.01)i
FI:     H01M10/42 P; H02J7/00 A; H01M50/284; H01M10/48 P; H01M50/204; H01M50/202 401D; H01M50/251;
H01M50/247; H01M50/249

According to International Patent Classification (IPC) or to both national classification and IPC

### B. FIELDS SEARCHED

Minimum documentation searched (classification system followed by classification symbols)

H01M10/42; H01M10/48; H01M50/202; H01M50/204; H01M50/247; H01M50/249; H01M50/251; H01M50/284; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2008/146587 A1 (PANASONIC EV ENERGY CO., LTD.) 04 December 2008 (2008-12-04)<br>paragraphs [0026]-[0044], fig. 1-3 | 1-15 |
| A | JP 2011-216329 A (PRIMEARTH EV ENERGY CO., LTD.) 27 October 2011 (2011-10-27)<br>paragraphs [0032]-[0033], [0036]-[0038], fig. 2 | 1-15 |
| A | JP 2020-8520 A (FDK CORP.) 16 January 2020 (2020-01-16)<br>paragraphs [0056]-[0072], fig. 3 | 1-15 |
| A | JP 2021-92404 A (GS YUASA CORP.) 17 June 2021 (2021-06-17)<br>paragraphs [0019]-[0021] | 1-15 |

☐ Further documents are listed in the continuation of Box C.          ☑ See patent family annex.

| | |
|---|---|
| *     Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **19 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/028287**

| Patent document cited in search report | | | Publication date (day/month/year) | Patent family member(s) | | | Publication date (day/month/year) |
|---|---|---|---|---|---|---|---|
| WO | 2008/146587 | A1 | 04 December 2008 | JP 2008-293703 A<br>US 2010/0047684 A1<br>paragraphs [0044]-[0075], fig. 1-3 | | | |
| JP | 2011-216329 | A | 27 October 2011 | US 2011/0239445 A1<br>paragraphs [0046]-[0047], [0051]-[0053], fig. 2 | | | |
| JP | 2020-8520 | A | 16 January 2020 | (Family: none) | | | |
| JP | 2021-92404 | A | 17 June 2021 | US 2023/0003809 A1<br>paragraphs [0049]-[0057]<br>WO 2021/112223 A1 | | | |

Form PCT/ISA/210 (patent family annex) (January 2015)

## EP 4 597 681 A1

**Patent documents cited in the description**

- JP 2021093247 A
- JP 2018156768 A
- JP 2009021021 A
- JP 2015076165 A